# EUROPEAN PATENT APPLICATION

(11) **EP 3 920 674 A1**
(43) Date of publication of application: **08.12.2021**
(21) Application number: 21153102.5
(22) Date of filing: 22.01.2021
(51) Int. Cl.: H05K 3/36, H05K 3/40

(54) **CIRCUIT CARD ASSEMBLY STACK WITH STAND-OFFS**

(30) Priority: 03.06.2020 US 202016891579
(71) Applicant: ROSEMOUNT AEROSPACE INC., Burnsville, MN 55306-4898 (US)
(72) Inventor: Whatcott, Neal R., Chaska, MN 55318 (US); Graham, Jason, Prior Lake, MN 55372 (US); Willenbring, Gary, Waconia, MN 55387 (US)
(74) Representative: Dehns

(57) **Abstract**

A stacked circuit card assembly (10) includes a power supply having a positive terminal and a negative terminal, a first circuit card (12) having a first via (32) electrically connected to the positive terminal and a second via (34) electrically connected to the negative terminal, and a second circuit card 914) having a third via aligned with the first via and a fourth via aligned with the second via. The assembly further includes a first conductive stand-off (52) disposed between the first circuit card and the second circuit card and structurally supporting the first circuit card with respect to the second circuit card, and a second conductive stand-off (60) disposed between the first circuit card and the second circuit card and structurally supporting the first circuit card with respect to the second circuit card. The first conductive stand-off provides a conductive pathway between the first via and the third via, and the second conductive stand-off provides a conductive pathway between the second via and the fourth via.

## Description

This invention was made with government support under Contract No. 2019-535 awarded by The United States Army. The government has certain rights in the invention.

### BACKGROUND

The disclosed subject matter generally relates to circuit card assemblies, and more particularly, to stacked circuit card assemblies using conductive stand-offs.

Many electronic systems include stacked circuit card assemblies. Providing a high current power bus to these assemblies and fitting the bus within the circuit card diameter on a small size, weight, and power (SWAP) package can be a challenge because most circuit card surface area is occupied by electrical components. Typically, high current connections require relatively large conductive paths, in comparison to signal connections. One space-saving approach includes sending power through connectors designed for signals. In such cases, the power must be distributed through multiple pins on the connector and the device must be derated (by limiting the number of adjacent pins supplying power or the current through each pin) to stay below the maximum current rating for the connector to avoid damage or failure from overheating. The recruitment of pins for power also reduces the number of pins available for transferring signals between circuit boards. Additionally, power components and signal components are preferably spaced apart to reduce noise coupling. Thus, a need exists for a compact and robust power transmission solution.

### SUMMARY

A stacked circuit card assembly includes a power supply having a positive terminal and a negative terminal, a first circuit card having a first via electrically connected to the positive terminal and a second via electrically connected to the negative terminal, and a second circuit card having a third via aligned with the first via and a fourth via aligned with the second via. The assembly further includes a first conductive stand-off disposed between the first circuit card and the second circuit card and structurally supporting the first circuit card with respect to the second circuit card, and a second conductive stand-off disposed between the first circuit card and the second circuit card and structurally supporting the first circuit card with respect to the second circuit card. The first conductive stand-off provides a conductive pathway between the first via and the third via, and the second conductive stand-off provides a conductive pathway between the second via and the fourth via.

### BRIEF DESCRIPTION OF THE DRAWINGS

FIG. 1 is a schematic perspective view of a stacked circuit card assembly with conductive stand-offs.
FIG. 2 is an enlarged cross-sectional view of a pair of adjacent circuit cards within the assembly showing the conductive components in greater detail.

While the above-identified figures set forth one or more embodiments of the present disclosure, other embodiments are also contemplated, as noted in the discussion. In all cases, this disclosure presents the invention by way of representation and not limitation. It should be understood that numerous other modifications and embodiments can be devised by those skilled in the art, which fall within the scope of the principles of the invention. The figures may not be drawn to scale, and applications and embodiments of the present invention may include features and components not specifically shown in the drawings.

### DETAILED DESCRIPTION

A circuit card assembly (CCA) includes a plurality of printed circuit cards in a stacked configuration. A pair of conductive stand-offs is disposed between adjacent circuit cards and extend into through hole vias in the circuit cards such that each circuit card in the stack is electrically connected to the others. A power connector supplies external power to the stack and can be positioned on one of the first or last (terminal) circuit cards in the stack. The conductive stand-offs are robust and can accommodate higher amperage than other designs as well as mechanically support the CCA. Further, the design positions the power connections near the periphery of the circuit cards keeping power components separate from other card components.

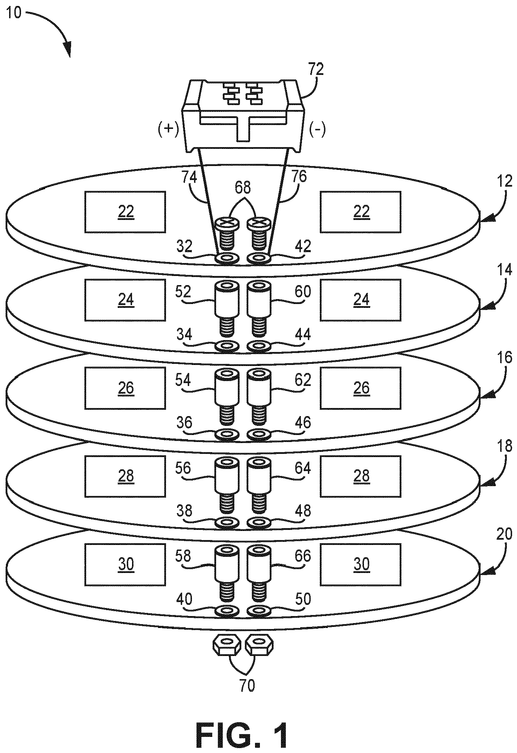

FIG. 1 is a schematic perspective view of a stacked circuit card assembly (CCA) 10 according to an embodiment of the present invention. CCA 10 includes five circuit cards 12, 14, 16, 18, and 20, (hereinafter collectively referred to as circuit cards 12-20) with circuit cards 12 and 20 being the first and last (i.e., outermost) circuit cards in CCA 10. Alternative embodiments of CCA 10 can include fewer (e.g., only two) circuit cards, or more than five, as necessary to meet spatial and/or operational requirements. Further, although shown having a uniform disc-shaped geometry, circuit cards 12-20 can have other geometries (e.g., rectangular, square, etc.) and can be uniform or can vary between cards.

Circuit cards 12-20 include respective circuit components 22, 24, 26, 28, and 30 (hereinafter components 22-30). Although represented schematically as being substantially similar, components 22-30 can either be uniform or differ from card to card and/or on the same card. Any of components 22-30 can be two or three dimensional and have various geometries. Components 22-30 can be connected to one another and/or elements of the power supply pathway with conductive trace or other conductive pathways. Components 22-30 can occupy a respective circuit card to various extents, for example, occupying greater than 50% of a circuit card's surface area.

Circuit cards 12-20 also include respective first vias 32, 34, 36, 38, and 40 (hereinafter first vias 32-40, or as sequential ordinal odd numbers first, third, etc.), and adjacent second vias 42, 44, 46, 48, and 50 (hereinafter second vias 42-50, or as sequential ordinal even numbers second, fourth, etc.). As shown, first vias 32-40 and second vias 42-50 are positioned near a periphery of their respective circuit card 12-20, and first vias 32-40 are generally vertically aligned with one another, as are second vias 42-50.

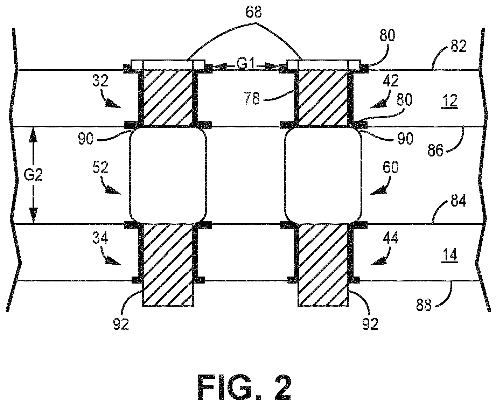

CCA 10 further includes conductive stand-offs positioned between adjacent circuit cards, all shown in an exploded configuration in FIG. 1 to facilitate visualization. More specifically, CCA 10 includes respective first stand-offs 52, 54, 56, and 58 (hereinafter stand-offs 52-58, or as sequential ordinal odd numbers), and second stand-offs 60, 62, 64, and 66 (hereinafter second stand-offs 60-66, or as sequential ordinal even numbers). First stand-offs 52-58 and second stand-offs 60-66 can be formed from a conductive material such as brass or other metallic material. Other conductive materials are contemplated herein. First stand-offs 52-58 and second stand-offs 60-66 physically and electrically connect circuit cards 12-20 as is discussed in greater detail below with respect to FIG. 2. Fasteners, such as screws 68 can be used can be used to secure circuit card 12 (an outermost circuit card) to stand-offs 52 and 60, while nuts 70 can be used to secure circuit card 20 (the opposing outermost circuit card) to stand-offs 58 and 66. Other fastener types are contemplated herein. Stand-offs are secured to one another through male and female ends, as is discussed in greater detail below.

CCA 10 includes power connector 72 which, as shown in FIG. 1, is in electrical communication with circuit card 12. Power connector 72 can have a positive terminal and a negative terminal, indicated respectively by (+) and (-). Pathway 74 connects positive terminal (+) to first via 32 and pathway 76 connects negative terminal (-) to second via 42. Pathways 74 and 76 can be, for example, conductive trace or direct connecting hardware depending on the placement and design of power connector 72. Depending on the embodiment, power connector 72 can be positioned on an upper or lower surface (labeled in FIG. 2) of circuit card 12, or on an upper or lower surface of another circuit card, such as circuit card 20. In some embodiments, power connector 72 can be connected directly to or cabled to an external power source. Alternatively, power connector 72 need not be used and the external power source can be directly connected to CCA 10.

FIG. 2 is a close-up partial cross-sectional view showing circuit cards 12 and 14 in via/stand-off region in greater detail. As shown in FIG. 2, first vias 32 and 34 and second vias 42 and 44 are through hole vias each with conductive plating 78 and conductive pads 80 on the outer surfaces 82 and 84 and inner surfaces 86 and 88 of circuit cards 12 and 14, respectively. Plating 78 and pads 80 are conductive materials such as copper, brass, or other conductive metallic material. A via gap G1 with no conductive material exists between pads 80 on a like surface (e.g., such that neighboring vias, like first via 32 and second via 42 are electrically isolated from one another). This helps reduce interference between adjacent vias.

A circuit card gap G2 is shown between inner surface 86 of circuit card 12 and outer surface 84 of circuit card 14. Gap G2 can be uniform throughout CCA 10 such that it is the same between neighboring circuit cards (e.g., 14 and 16, 18 and 20, etc.), or it can vary, depending, for example, on a need to provide suitable clearance for three dimensional components on a particular circuit card. The size of gap G2 will depend, in part, on the dimensions of the first and second stand-offs (e.g., 52 and 60). Gap G2 is additionally sized to prevent signal and/or electrical interference between components on adjacent circuit cards.

First stand-off 52 and second stand-off 60 each include a female end 90 and a male end 92. As shown in FIG. 2, female ends 90 receive the threading of screws 68, as circuit card 12 is an outermost/first circuit card. Subsequent intermediate stand-offs (e.g., first stand-off 54 and second stand-off 62 of FIG. 1) can receive at their female ends 90 the male end 92 of the preceding stand-off pair. Male ends 92 of stand-offs 52 and 60 extend through vias 34 and 44, respectively, for threading into subsequent stand-offs 54 and 62 (not shown in FIG. 2). This is true for the remaining stand-offs except for stand-offs 58 and 66 which extend through vias 40 and 50, respectively, of circuit card 20, which is an outermost/last circuit card. In this case, nuts 70 (shown in FIG. 1) are threaded onto male ends 92. The threading arrangement of fasteners and stand-offs provides rigid support for CCA 10, and also permits for removal of circuit cards from CCA 10 for modification or maintenance purposes.

Circuit cards 12-20 are electrically connected by conductive first stand-offs 52-58 and conductive second stand-offs 60-66 in communication with plated first vias 32-40 and plated second vias 42-50, respectively. In the embodiment of FIGS. 1 and 2, first vias 32-40 serve as respective power contacts, while second vias 42-50 serve as respective return power contacts for circuit cards 12-20. Power contacts 32-40 provide power to respective components 22-30 of circuit cards 12-20 and can be connected to power contacts 32-40 by, for example, conductive traces. Each first and second stand-off pair (e.g., first stand-off 52 and second stand-off 60) acts as a power bus with a power pathway (e.g., first stand-off 52) and a power return pathway (e.g., second stand-off 60). Collectively, first stand-offs 52-58 act as a power pathway and second stand-offs 60-66 as the power return pathway of CCA 10. In an alternative embodiment, one or more circuit cards 12-20 can include additional first and second vias and stand-offs as necessary to meet power requirements.

The disclosed circuit card assembly has many advantages over existing designs. First, the design confines the via and stand-off pairs to a periphery of each circuit card and away from other circuit components (e.g., components 22-30) to minimize electrical interference. The conductive stand-offs are a larger gauge than individual pins of signal connectors, thus, they can be supplied with a higher current than individual or groups of pins without requiring power derating. Conductive stand-offs further provide rigid support to the circuit card assembly and provide adequate inter-card spacing to accommodate components and reduce electrical interference. The multi-purpose stand-offs obviate the need for separate structural and power bus componentry creating a smaller power supply footprint. This is advantageous over existing designs having distinct power connectors, as well as those supplying power through signal connectors. The disclosed assemblies can be used in various applications, including aviation and other transportation industries.

### Discussion of Possible Embodiments

The following are non-exclusive descriptions of possible embodiments of the present invention.

A stacked circuit card assembly includes a power supply having a positive terminal and a negative terminal, a first circuit card having a first via electrically connected to the positive terminal and a second via electrically connected to the negative terminal, and a second circuit card having a third via aligned with the first via and a fourth via aligned with the second via. The assembly further includes a first conductive stand-off disposed between the first circuit card and the second circuit card and structurally supporting the first circuit card with respect to the second circuit card, and a second conductive stand-off disposed between the first circuit card and the second circuit card and structurally supporting the first circuit card with respect to the second circuit card. The first conductive stand-off provides a conductive pathway between the first via and the third via, and the second conductive stand-off provides a conductive pathway between the second via and the fourth via.

The assembly of the preceding paragraph can optionally include, additionally and/or alternatively, any one or more of the following features, configurations and/or additional components:

In the above assembly, the first conductive stand-off and second conductive stand-off each can each include a male end and a female end, and the male end of the first conductive stand-off can extend through the third via, and the male end of the second conductive stand-off can extend through the fourth via.

Any of the above assemblies can further include a first via gap separating and electrically isolating the first via from the second via, and a second via gap separating and electrically isolating the third via from the fourth via.

Any of the above assemblies can further include a first fastener extending through the first via of the first circuit card and threaded into the female end of the first conductive stand-off, and a second fastener extending through the second via of the first circuit card and threaded into the female end of the second conductive stand-off.

In any of the above assemblies, each of the first, second, third, and fourth vias are through-hole vias plated with a conductive material.

Any of the above assemblies can further include an electrical pathway within the first circuit card electrically connecting the power supply to each of the first and second through-hole vias.

In any of the above assemblies, the electrical pathway can include conductive trace.

In any of the above assemblies, the power supply can include a power connector connected to an external power source, or an external power source in direct contact with the conductive pathway.

Any of the above assemblies can further include a third circuit card having a fifth via aligned with the first and third vias, and a sixth via aligned with the second and fourth vias. The assembly can further include a third conductive stand-off disposed between the second circuit card and the third circuit card and structurally supporting the second circuit card with respect to the third circuit card, and a fourth conductive stand-off disposed between the second circuit card and the third circuit card and structurally supporting the second circuit card with respect to the third circuit card. The third conductive stand-off can provide a conductive pathway between the third via and the fifth via, and the fourth conductive stand-off can provide a conductive pathway between the fourth via and the sixth via.

In any of the above assemblies, the third conductive stand-off and fourth conductive stand-off can each include a male end and a female end, and the male end of the third conductive stand-off can extend through the fifth via, and the male end of the fourth conductive stand-off can extend through the sixth via.

Any of the above assemblies can further include a first nut threaded onto the male end of the third conductive stand-off, and a second nut threaded onto the male end of the fourth conductive stand-off.

In any of the above assemblies, the male end of the first conductive stand-off can be threaded into the female end of the third conductive stand-off, and the male end of the second conductive stand-off can be threaded into the female end of the fourth conductive stand-off.

In any of the above assemblies, the first, second, third, and fourth conductive stand-offs can be made of brass.

In any of the above assemblies, a geometry of the first, second, and third circuit cards can be uniform.

In any of the above assemblies, the geometry of the first, second, and third circuit cards can be one of a disc and a quadrilateral shape.

Any of the above assemblies can further include a first gap between a bottom surface of the first circuit card and a top surface of the second circuit card, and a second gap between the bottom surface of the second circuit card and a top surface of the third circuit card.

In any of the above assemblies, the first gap and the second gap can be uniform.

In any of the above assemblies, the first gap and the second gap can be different.

In any of the above assemblies, the first, third, and fifth vias can be configured as power contacts, and the second, fourth, and sixth vias can be configured as power return contacts.

Any of the above assemblies can further include a fourth circuit card and a fifth circuit card disposed between the first and third circuit cards.

While the invention has been described with reference to an exemplary embodiment(s), it will be understood by those skilled in the art that various changes may be made and equivalents may be substituted for elements thereof without departing from the scope of the invention as defined by the claims. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. A stacked circuit card assembly (10) comprising:
a power supply having a positive terminal and a negative terminal;
a first circuit card (12) having a first via (32) electrically connected to the positive terminal and a second via (34) electrically connected to the negative terminal;
a second circuit card (14) having a third via (34) and a fourth via (44), the third via being aligned with the first via, and the fourth via being aligned with the second via;
a first conductive stand-off (52) disposed between the first circuit card and second circuit card and structurally supporting the first circuit card with respect to the second circuit card; and
a second conductive stand-off (60) disposed between the first circuit card and second circuit card and structurally supporting the first circuit card with respect to the second circuit card;
wherein the first conductive stand-off provides a conductive pathway between the first via and the third via, and the second conductive stand-off provides a conductive pathway between the second via and the fourth via.

2. The assembly of claim 1, wherein the first conductive stand-off and second conductive stand-off each comprise a male end and a female end, and wherein the male end of the first conductive stand-off extends through the third via, and the male end of the second conductive stand-off extends through the fourth via.

3. The assembly of claim 1 or 2, and further comprising:
a first via gap (G1) separating and electrically isolating the first via from the second via; and
a second via gap separating and electrically isolating the third via from the fourth via.

4. The assembly of any preceding claim, and further comprising:
a first fastener extending through the first via of the first circuit card and threaded into the female end of the first conductive stand-off; and
a second fastener extending through the second via of the first circuit card and threaded into the female end of the second conductive stand-off.

5. The assembly of any preceding claim, wherein each of the first, second, third, and fourth vias are through-hole vias plated with a conductive material.

6. The assembly of any preceding claim, further comprising: an electrical pathway within the first circuit card electrically connecting the power supply to each of the first and second through-hole vias; and optionally wherein the electrical pathway comprises conductive trace.

7. The assembly of any preceding claim, wherein the power supply comprises:
a power connector (72) connected to an external power source; or
an external power source in direct contact with the conductive pathway.

8. The assembly of any preceding claim, further comprising:
a third circuit card (16) having a fifth via (36) and a sixth via (46), the fifth via being aligned with the first via of the first circuit card and the third via of the second circuit card, and the sixth via being aligned with the second via of the first circuit card and the fourth via of the second circuit card;
a third conductive stand-off (54) disposed between the second circuit card and third circuit card and structurally supporting the second circuit card with respect to the third circuit card; and
a fourth conductive stand-off (62) disposed between the second circuit card and third circuit card and structurally supporting the second circuit card with respect to the third circuit card;
wherein the third conductive stand-off provides a conductive pathway between the third via and the fifth via, and the fourth conductive stand-off provides a conductive pathway between the fourth via and the sixth via; and optionally further comprising: a fourth circuit card (18) and a fifth circuit card (20) disposed between the first and third circuit cards.

9. The assembly of claim 8, wherein the third conductive stand-off and fourth conductive stand-off each comprise a male end and a female end, and wherein the male end of the third conductive stand-off extends through the fifth via, and the male end of the fourth conductive stand-off extends through the sixth via.

10. The assembly of claim 9 and further comprising:
a first nut (70) threaded onto the male end of the third conductive stand-off; and
a second nut (70) threaded onto the male end of the fourth conductive stand-off; and optionally wherein the male end of the first conductive stand-off is threaded into the female end of the third conductive stand-off, and wherein the male end of the second conductive stand-off is threaded into the female end of the fourth conductive stand-off.

11. The assembly of claim 8, 9, or 10, wherein the first, second, third, and fourth conductive stand-offs are made of brass.

12. The assembly of claim 8, 9, 10, or 11, wherein a geometry of the first, second, and third circuit cards is uniform; and optionally wherein the geometry of the first, second, and third circuit cards is one of a disc and a quadrilateral shape.

13. The assembly of any of claims 8 to 12 and further comprising:
a first gap (G2) between a bottom surface of the first circuit card and a top surface of the second circuit card; and
a second gap between the bottom surface of the second circuit card and a top surface of the third circuit card.

14. The assembly of claim 13, wherein the first gap and the second gap are uniform; or wherein the first gap and the second gap are different.

15. The assembly of any of claims 8 to 14, wherein the first, third, and fifth vias are configured as power contacts, and wherein the second, fourth, and sixth vias are configured as power return contacts.
